# EUROPÄISCHE PATENTANMELDUNG

(11) **EP 4 270 452 A1**
(43) Veröffentlichungstag der Anmeldung: **01.11.2023**
(21) Anmeldenummer: 22170041.2
(22) Anmeldetag: 26.04.2022
(51) Int. Cl.: H01L 21/48, H01L 23/373, B22F 7/06, B22F 7/08, B22F 10/28, B33Y 80/00

(54) **FÜGEN EINES PULVERBASIERT ADDITIV GEFERTIGTEN METALLISCHEN KÖRPERS**

(71) Anmelder: Siemens Aktiengesellschaft, 80333 München (DE)
(72) Erfinder: Jeske, Nora, 10555 Berlin (DE)
(74) Vertreter: Siemens Patent Attorneys

(57) **Zusammenfassung**

Die Erfindung betrifft ein Verfahren zum Fügen eines mittels eines pulverbasiert additiven Fertigungsprozesses gefertigten metallischen Körpers (40) an eine thermische Schnittstelle (110) eines Objekts (100), umfassend die Schritte:
- Bereitstellen des Körpers (40), der zumindest an einer Fügefläche (42) Metallpartikel (50) aufweist, und eines Lotmaterials (60), sodass die Metallpartikel (50) zwischen dem Lotmaterial und der Fügefläche (42) angeordnet sind,
- Löten der Fügefläche (42) des Körpers (40) an die thermische Schnittstelle (110), sodass sich aus dem Lotmaterial (60) und den Metallpartikeln (50) zumindest teilweise intermetallische Phasen (56) ausbilden. Die Erfindung betrifft weiterhin eine leistungselektronische Baugruppe sowie ein Halbzeug.

## Beschreibung

Die Erfindung betrifft ein Verfahren zum Fügen eines pulverbasiert additiv gefertigten metallischen Körpers an eine thermische Schnittstelle eines Objekts. Die Erfindung betrifft weiterhin eine leistungselektronische Baugruppe sowie ein Halbzeug.

Ein derartiges Verfahren kommt beispielsweise beim Herstellen von leistungselektronischen Baugruppen mit hoher Leistungsdichte zum Einsatz. Die leistungselektronischen Baugruppen können dabei in Anwendungen mit hoher Leistungsdichten z. B. Umrichter, Gleichrichter, Wechselrichter und weitere leistungselektronischen Komponenten zum Einsatz kommen.

Beim Einsatz von elektronischen Bauteilen, wie beispielsweise leistungselektronischen Halbleiterbauteilen, entsteht Wärme, die üblicherweise über einen Kühlkörper abgeführt wird. Hierfür werden Kühlkörper, z.B. aus Cu, verwendet, auf die ganzen Module oder einzelnen Bauteile, z.B. mittels Leitkleber, aufgeklebt werden. Der Leitkleber beschränkt durch seine geringe Wärmeleitfähigkeit jedoch die Wärmeabfuhr aus den darüber liegenden Schichten. Um höhere Leistungen und kleinere Packungsdichten zu ermöglichen ist eine temperaturbeständige, hoch wärmeleitfähige Verbindungsschicht zwischen Kühlkörper und Bauteil oder Modul notwendig. Neue Aufbau- und Verbindungstechnologien wie das Silber-Sintern oder Diffusionslöten ermöglichen grundsätzlich das Herstellen einer hoch temperaturbeständigen und hoch wärmeleitenden Verbindungsschicht. Für einen Einsatz bei größeren Verbindungsflächen insbesondere Kühlkörperanbindungen sind diese Verfahren jedoch bisher nicht geeignet. Silber-Sinterfahren benötigen häufig einen Anpressdruck bei der Herstellung, so dass drucksensible Bauteile oder große Flächen nicht gefertigt werden können.

Der Erfindung liegt die Aufgabe zugrunde, ein Verfahren anzugeben, dass eine hochtemperaturstabile Anbindung von Objekten einem verringerten Anpressdruck ermöglicht.

Diese Aufgabe wird durch ein Verfahren mit den im Anspruch 1 angegebenen Merkmalen gelöst.

Zum Fügen eines mittels eines pulverbasierten additiven Fertigungsprozesses gefertigten metallischen Kühlkörpers an eine thermische Schnittstelle eines Objekts werden die folgenden Schritte vorgeschlagen:
- Bereitstellen des Körpers, der zumindest an einer Fügefläche Metallpartikel aufweist und eine Lotmaterials, sodass die Metallpartikel zwischen dem Lotmaterial und der Fügefläche angeordnet sind, und
- Löten der Fügefläche des Körpers an die thermische Schnittstelle, sodass sich aus dem Lotmaterial und den Metallpartikeln zumindest teilweise intermetallische Phasen ausbilden.

Mittels pulverbasierten additiven Herstellungsverfahrens hergestellte Objekte, insbesondere Kühlkörper, können komplexe und dementsprechend effiziente Geometrien hinsichtlich Wärmeübertragung und Wärmeabtransport aufweisen. Als Herstellungsverfahren kommen beispielsweise selektives Lasersintern, selektives Laserschmelzen oder Elektronenstrahlschmelzen in Frage. Derartige Objekte verbessert an eine thermische Schnittstelle anzubinden, ermöglicht das erfindungsgemäße Verfahren. Die Metallpartikel können dabei aus dem Pulver sein, das beim Herstellungsverfahren zur Anwendung kommt und können sich dabei noch vom Herstellungsprozess auf der Fügefläche befinden. Ein Reinigungsverfahren für die Fügefläche kann somit übersprungen oder in weniger intensiver Ausführung durchgeführt werden. Durch die Metallpartikel ist es möglich, dass die aus dem Lotmaterial und den Metallpartikeln entstehende Lotschicht mit intermetallischen Phasen durchwächst und so eine besonders gute thermische Anbindung erreicht.

Das Löten der Fügefläche kann dabei drucklos oder mit geringem Druck erfolgen, womit das Objekt, die thermische Schnittstelle sowie der Körper geschont werden und empfindliche Körper sowie Objekte verarbeitet werden können.

In einer weiteren Ausführungsform bestehen die Metallpartikel aus dem Material, das zum Herstellen des Körpers verwendet wurde. Es kann sich dabei um Metallpulver handeln, insbesondere ein Kupferpulver, das vorzugsweise aus derselben Charge kommt wie das Pulver, das zum Herstellen des Körpers verwendet wurde.

In einer weiteren Ausführungsform stammen die Metallpartikel aus dem Fertigungsprozess des Körpers. Werden die Metallpartikel direkt aus dem Fertigungsprozess des Körpers entnommen und/oder haften diese bereits an dem Körper und/oder der Fügefläche, so muss das Material nicht separat vorgehalten werden und hat einen ähnlichen Temperaturverlauf erfahren wie der Körper selbst.

In einer besonders vorteilhaften Ausführungsform stammen die Metallpartikel zumindest teilweise, insbesondere ausschließlich, aus einem Pulverbett des Fertigungsprozesses des Körpers. Dies kann beispielsweise der Fall sein, wenn der Körper aus dem Pulverbett entnommen wird und noch einige Metallpartikel daran haften.

In einer weiteren Ausführungsform ist das Löten so ausgestaltet, dass sich zwischen den Metallpartikeln, dem Lot und der Fügefläche intermetallische Phasen ausbilden. Das Ausbilden der intermetallischen Phasen ist im Wesentlichen von den Bedingungen während des Lotvorgangs abhängig. So kann der Lotvorgang so ausgestaltet sein, dass ein Wachstum der intermetallischen Phasen begünstigt wird. Dies kann beispielsweise durch einen entsprechenden Temperatur- und/oder Druckverlauf sichergestellt werden.

In einer weiteren Ausführungsform wird beim Bereitstellen des Körpers ein Reinigungsvorgang und/oder eine Oberflächennachbehandlung der Fügefläche übersprungen. Dies kann in vorteilhafter Weise dazu führen, dass auf der Fügefläche ausreichend Metallpartikel aus dem Herstellungsverfahren des Körpers verbleiben, die dann Diffusionszonen mit dem Lot bilden können. Darüber hinaus können die aufwändigen Vorgänge und Nachbehandlungen vereinfacht werden und der Körper direkt weiterverwendet werden.

In einer weiteren Ausführungsform wird zumindest die Fügefläche des Körpers so bereitgestellt, wie sie im Fertigungsprozess erzeugt wird. Durch in additiv pulverbasierten Verfahren erzeugten Oberflächen weisen eine gewisse Oberflächenrauigkeit mit gewissen teilweise regelmäßigen Unebenheiten auf. Diese Unebenheiten können zu einer weiteren Verbesserung des Wärmeübergangs durch Bildung von Diffusionszonen führen. Insbesondere in Verbindung mit den Metallpartikeln wird so eine Hohldurchdringung mit Diffusionszonen ermöglicht. In anderen Worten wird die Fügefläche unverändert aus dem Fertigungsprozess bereitgestellt.

In einer weiteren Ausführungsform ist der Körper ein Kühlkörper, der beispielsweise Kühlfinnen und/oder weitere durch Fluide durchströmbare Kühlstrukturen aufweist. Weiterhin können der Körper und die Metallpartikel vorteilhaft aus Kupfer oder Kupferlegierungen bestehen.

In einer weiteren Ausführungsform wird das Lotmaterial auf der Fügefläche bereitgestellt. Dies kann insbesondere derart geschehen, dass das Lotmaterial die Materialpartikel auf der Fügefläche fixiert. Es kann sich dabei um vorgeformte Lotdepots handeln, die auf die Fügefläche aufgebracht werden. Alternativ oder ergänzend kann es sich um Lotmaterial handeln, das im Vergleich zum tatsächlichen Fügevorgang bei niedrigeren Temperaturen und in kürzerer Zeitspanne vorgelötet wird und bereits teilweise eine Lotverbindung mit der Fügefläche bildet, ohne dabei die Lötbarkeit zu verlieren. Der Vorteil liegt hier darin, dass die Partikel fixiert sind, durch den Transport nicht mehr von dem Körper entfernt werden und sich eine gewisse Korrosionsbeständigkeit einstellt.

Die Aufgabe wird weiterhin durch eine leistungselektronische Baugruppe gelöst, die zumindest ein Substrat mit einer Metallisierung und eine thermische Schnittstelle aufweist. Weiterhin weist die Baugruppe zumindest ein leistungselektronisches Halbleiterbauelement und einen mittels eines pulverbasiert additiven Fertigungsprozesses gefertigten metallischen Körper auf. Der Körper weist dabei eine Fügefläche auf, die derart wärmeleitend an die thermische Schnittstelle gelötet ist, dass ein Lotmaterial, das zwischen der thermischen Schnittstelle und der Fügefläche angeordnet ist und Metallpartikel, die ebenfalls dort angeordnet sind, intermetallische Phasen ausbildet. Dies hat den Vorteil, dass durch die intermetallischen Phasen die thermische Anbindung des vorzugsweise als Kühlkörper ausgebildeten Körpers an die thermische Schnittstelle, also an die Wärmeerzeugende Baugruppe, erheblich verbessert wird.

In einer alternativen oder ergänzenden Ausführungsform weist die Baugruppe ein Substrat mit einer Metallisierung, ein oder mehrere leistungselektronische Halbleiterbauelemente und einen mittels eines pulverbasiert additiven Fertigungsprozesses gefertigten metallischen Körper auf. Der Körper ist dabei derart mit der Fügefläche wärmeleitend an zumindest eines der leistungselektronischen Halbleiterbauelemente gelötet, dass ein Lotmaterial und die Metallpartikel intermetallische Phasen ausbilden. Die Halbleiterbauelemente können dabei auch Metallisierungen aufweisen, die ebenso intermetallische Phasen mit samt dem Lotmaterial und den Metallpartikeln ausbilden können. Die Körper sind vorzugsweise als Kühlkörper ausgebildet. Weiterhin sind die Körper vorzugsweise aus Kupfer gefertigt. Entsprechende pulverbasierte Kupferlegierungen können dabei verwendet werden. Ergänzend oder alternativ kann der Körper derart mit der Fügefläche wärmeleitend an zumindest eines der leistungselektronischen Halbleiterbauelemente gelötet sein, dass das Lotmaterial und die Metallpartikel intermetallische Phasen ausbilden. Durch entsprechende Fügebedingungen während des Lötens können die intermetallischen Phasen das Lot vollständig durchdringen und sowohl eine thermische Schnittstelle der Halbleiterbauelemente bzw. der Metallisierung erreichen.

In einer weiteren Ausführungsform bestehen die Metallpartikel aus dem Material, das zum Herstellen des Körpers verwendet wurde. Die eingangs genannten Ausführungsformen des Verfahrens sind ebenso auf die Ausführung der elektronischen Baugruppen anwendbar.

Die Aufgabe wird weiterhin durch ein Halbzeug gelöst, das einen mittels eines pulverbasiert additiven Fertigungsprozesses gefertigten metallischen Körper aufweist, der zumindest an einer Fügefläche Metallpartikel aufweist, die aus dem additiven Fertigungsprozess stammen. Auf der Fügefläche ist weiterhin ein Lotmaterial aufgebracht, sodass die Partikel zwischen dem Lotmaterial und der Fügefläche eingeschlossen sind. Dies hat den Vorteil, dass ein derartiges Halbzeug die Partikel einschließt und versiegelt, und einen einfachen Transport und Handhabung der so vorbereiteten Halbzeuge ermöglicht.

In anderen Worten können mit dem eingangs beschriebenen Verfahren Kühlkörper verwendet werden, die durch ein Aufschmelzen von Metallpulvern mittels Additive Manufacturing Verfahren bereitgestellt werden. Dabei werden bspw. Cu-Pulver, z.B. mit Hilfe eines Lasers, aufgeschmolzen, um eine feste Verbindung zu bilden. Auf der Oberfläche des so hergestellten Kühlkörpers ist, ohne die Anwendung eines Reinigungsverfahrens, weiterhin ein Rest Cu-Pulver vorhanden. Wird nun ein Lotwerkstoff auf diese Oberfläche (mit Cu-Pulver Resten) aufgetragen, so entsteht eine Vermengung des Lotwerkstoffs mit dem Cu-Pulver. Im Lötprozess bilden sich an der Grenzfläche zum Cu intermetallische Phasen aus, die durch eine besonders hohe Wärmeleitfähigkeit und Temperaturbeständigkeit ausgeprägt sind. Der besondere Vorteil der Cu-Partikel aus dem AM Verfahren liegt darin, dass hier zusätzliches Cu bereitgestellt wird, an dessen Grenzfläche sich intermetallische Phasen ausbilden können. Ein Durchwachsen der Verbindungsschicht ist damit möglich, so dass sich die gewünschte Verbindungschicht zwischen Kühlkörper und Modul oder Bauteil bzw. der jeweiligen thermischen Schnittstelle ausbildet. Vorteile ergeben sich hier durch eine deutliche Verbesserung der Wärmeleitfähigkeit sowie der Temperaturbeständigkeit der Kühlkörperanbindung. Zusätzlich können kostenintensive Schritte der Reinigung oder des mechanischen Abtrags von Rest-Metallpulvern auf der Oberfläche von AM Kühlkörpern wegfallen.

Im Folgenden wird die Erfindung anhand der in den Figuren dargestellten Ausführungsbeispiele näher beschrieben und erläutert. Es zeigen:
- FIG 1: schematisch ein Objekt und einen daran gefügten Körper,
- FIG 2: ein Schliffbild einer Lotverbindung,
- FIG 3: eine Ausführungsform einer leistungselektronischen Baugruppe,
- FIG 4: eine alternative und/oder ergänzende Ausführungs-form einer leistungselektronischen Baugruppe und
- FIG 5: eine Kombination der Ausführungsformen einer leis-tungselektronischen Baugruppe.

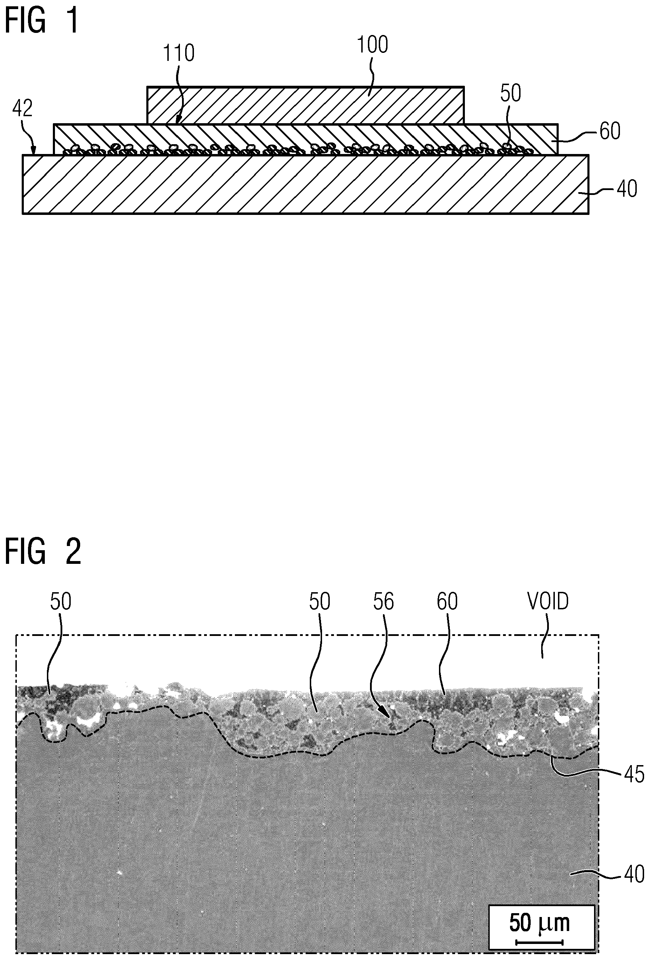

FIG 1 zeigt schematisch ein Objekt 100 mit einer thermischen Schnittstelle 110, die über ein Lotmaterial 60 an ein mittels eines pulverbasiert additiven Fertigungsprozesses gefertigten metallischen Körper 40 thermisch angebunden ist. Die thermische Anbindung des Körpers geschieht über eine Fügefläche 42 des Körpers, auf der Metallpartikel 50 angeordnet sind, die hier im vorliegenden Fall bereits teilweise in das Lotmaterial 60 eingebettet sind. So entsteht bei einem Lötvorgang zwischen den Metallpartikeln, der Fügefläche und dem Lotmaterial intermetallische Phasen. Diese verbessern den Wärmeübergang zwischen dem Objekt 100 und dem Körper 40 erheblich.

FIG 2 zeigt ein Schliffbild einer tatsächlichen Lotverbindung eines Körpers 40, der mittels eines pulverbasierten additiven Fertigungsverfahrens gefertigt wurde. Zu sehen sind die Metallpartikel 50, die bereits in ein Lotmaterial 60 eingebettet sind. Weiterhin sind durch die Fertigung des Körpers 40 entstehende Unebenheiten 45 eingezeichnet, die wiederum ebenfalls zu einer verbesserten Verbindung zwischen dem Lot, den Metallpartikeln und einem gegebenenfalls dann daran angebundenen Objekt 100 führten. Der mit VOID gekennzeichnete Bereich, ist in diesem Fall nicht befüllt. Anstelle des Bereichs VOID könnte ein Objekt 100 angefügt werden. Weiterhin zu sehen sind intermetallische Phasen 56, die nur beispielhaft an einer Position eingezeichnet sind. Derartige intermetallische Phasen 56 haben sich darüber hinaus an anderen Partikeln 50 im Lotmaterial 60 gebildet und verbessern den thermischen Kontakt.

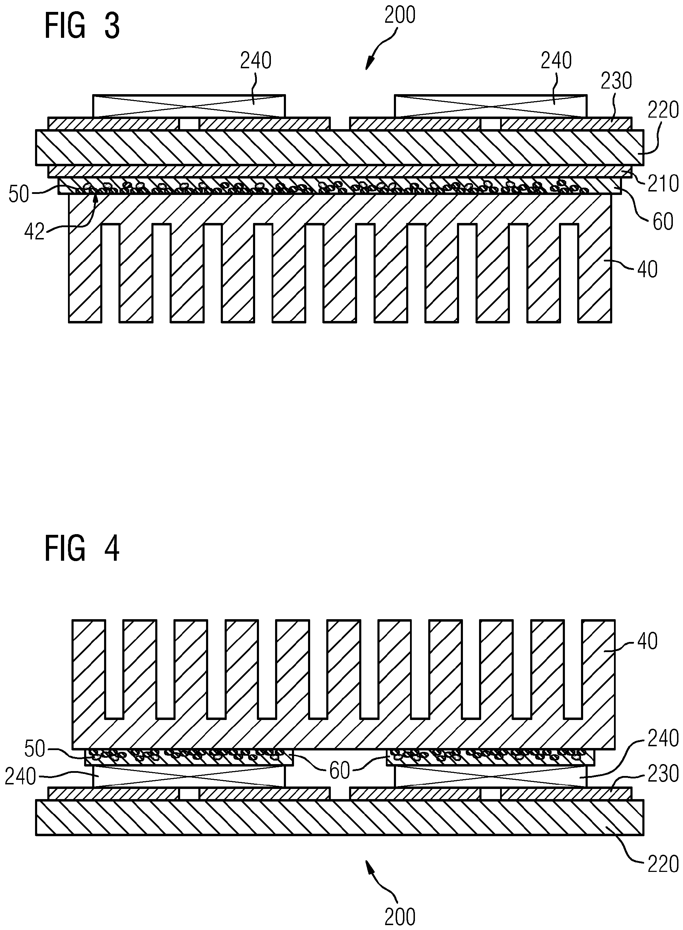

FIG 3 zeigt eine leistungselektronische Baugruppe 200, die vorliegend zwei leistungselektronische Halbleiterbauelemente 240, beispielsweise Dioden oder Halbleiterschalter aufweist. Die leistungselektronischen Halbleiterbauelemente 240 sind dabei auf eine Metallisierung 230, die strukturiert ist, sodass eine elektrische Kontaktierung der Halbleiterbauelemente 240 ermöglicht wird, aufgebracht. Die Metallisierung 230 ist wiederum auf einem Substrat 220 aufgebracht. Das Substrat 220 weist neben der Metallisierung 230 auch eine thermische Schnittstelle 210 auf. An diese thermische Schnittstelle 210 ist über ein Lotmaterial 60 ein als Kühlkörper ausgebildeter Körper 40, der an seiner Fügefläche 42 Metallpartikel 50 aufweist, angefügt. Der Kühlkörper ist hier schematisch als einfacher Kühlkörper 40 mit Fingen gezeichnet, da es sich aber um ein additiv und pulverbasiert gefertigten Körper 40 handelt, können die Strukturen erheblich komplexer ausgebildet sein. Auch Strukturen zum Durchfluss von Fluiden sind hier denkbar.

FIG 4 zeigt eine Alternative oder ergänzende Ausführungsform der leistungselektronischen Baugruppe 200 aus FIG 3. Hier ist der Kühlkörper 40 auf den leistungselektronischen Halbleiterbauelementen 240 mittels eines Lotmaterials 60 und den darin enthaltenen Metallpartikeln 50 thermisch angebunden. Das Substrat 220 und die Metallisierung 230 sind, wie in FIG 3 ausgestaltet.

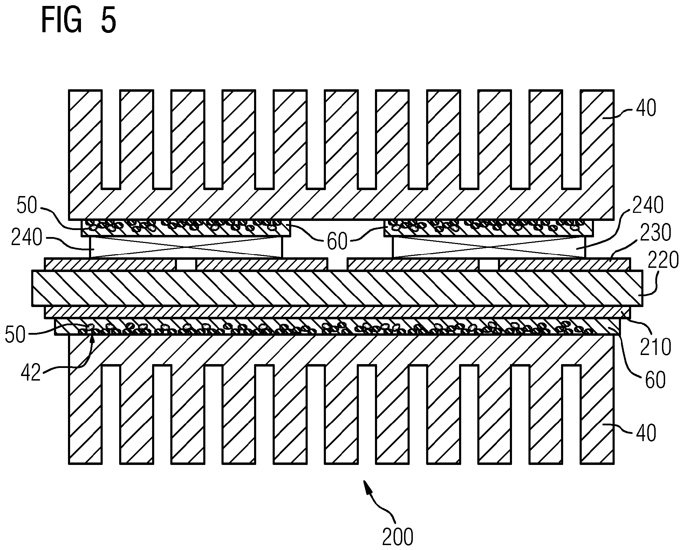

FIG 5 zeigt eine Ausführungsform, die für eine besonders hohe thermische Belastung, beispielsweise bei hoher Leistungsdichte, ausgeführt ist. Hier sind beidseitig Kühlkörper 40 mit dem erfindungsgemäßen Verfahren angebracht, wie es in den FIG 3 und 4 gezeigt ist.

Zusammenfassend betrifft die Erfindung ein Verfahren zum Fügen eines mittels eines pulverbasiert additiven Fertigungsprozesses gefertigten metallischen Körpers (40) an eine thermische Schnittstelle (110) eines Objekts (100), umfassend die Schritte:
- Bereitstellen des Körpers (40), der zumindest an einer Fügefläche (42) Metallpartikel (50) aufweist, und eines Lotmaterials (60), sodass die Metallpartikel (50) zwischen dem Lotmaterial und der Fügefläche (42) angeordnet sind,
- Löten der Fügefläche (42) des Körpers (40) an die thermische Schnittstelle (110), sodass sich aus dem Lotmaterial (60) und den Metallpartikeln (50) zumindest teilweise intermetallische Phasen (56) ausbilden. Die Erfindung betrifft weiterhin eine leistungselektronische Baugruppe sowie ein Halbzeug.

### Bezugszeichen

- 40: mittels eines pulverbasiert additiven Fertigungsprozesses gefertigter metallischer Körper
- 42: Fügefläche des Körpers
- 45: durch den Fertigungsprozess bedingte Unebenheiten
- 50: Metallpartikel
- 56: intermetallische Phasen
- 60: Lotmaterial
- 100: Objekt
- 110: thermische Schnittstelle des Objekts
- 200: Leistungselektronische Baugruppe
- 210: thermische Schnittstelle der Baugruppe
- 220: Substrat
- 230: strukturierte Metallisierung
- 240: leistungselektronische Halbleiterbauelemente

## Patentansprüche

1. Verfahren zum Fügen eines mittels eines pulverbasiert additiven Fertigungsprozesses gefertigten metallischen Körpers (40) an eine thermische Schnittstelle (110) eines Objekts (100), umfassend die Schritte:
- Bereitstellen des Körpers (40), der zumindest an einer Fügefläche (42) Metallpartikel (50) aufweist, und eines Lotmaterials (60), sodass die Metallpartikel (50) zwischen dem Lotmaterial und der Fügefläche (42) angeordnet sind,
- Löten der Fügefläche (42) des Körpers (40) an die thermische Schnittstelle (110), sodass sich aus dem Lotmaterial (60) und den Metallpartikeln (50) zumindest teilweise intermetallische Phasen (56) ausbilden.

2. Verfahren nach Anspruch 1, wobei die Metallpartikel (50) aus dem Material bestehen, das zum Herstellen des Körpers (40) verwendet wurde.

3. Verfahren nach Anspruch 1 oder 2, wobei die Metallpartikel (50) aus dem Fertigungsprozess des Körpers (40) stammen.

4. Verfahren nach einem der vorhergehenden Ansprüche, wobei die Metallpartikel (50) zumindest teilweise, insbesondere ausschließlich, aus einem Pulverbett des Fertigungsprozesses des Körpers (40) stammen.

5. Verfahren nach einem der vorhergehenden Ansprüche, wobei das Löten so ausgestaltet ist, dass sich zwischen den Metallpartikeln, dem Lot und der Fügefläche (42) intermetallische Phasen (56) ausbilden.

6. Verfahren nach einem der vorhergehenden Ansprüche, wobei beim Bereitstellen des Körpers (40) ein Reinigungsvorgang und/oder eine Oberflächennachbehandlung der Fügefläche (42) übersprungen wird.

7. Verfahren nach einem der vorhergehenden Ansprüche, wobei beim Bereitstellen des Körpers (40) zumindest die Fügefläche (42) so bereitgestellt wird, wie sie durch den Fertigungsprozess erzeugt wird.

8. Verfahren nach einem der vorhergehenden Ansprüche, wobei der Körper (40) ein Kühlkörper ist.

9. Verfahren nach einem der vorhergehenden Ansprüche, wobei der Körper (40) und die Metallpartikel (50) aus Kupfer bestehen.

10. Verfahren nach einem der vorhergehenden Ansprüche, wobei das Lotmaterial (60) auf der Fügefläche (42) bereitgestellt wird, insbesondere derart, dass das Lotmaterial (60) die Metallpartikel (50) auf der Fügefläche fixiert.

11. Leistungselektronische Baugruppe (200), die zumindest
- ein Substrat (220) mit einer Metallisierung (230) und einer thermischen Schnittstelle (210),
- zumindest ein leistungselektronisches Halbleiterbauelement (240) und
- einen mittels eines pulverbasiert additiven Fertigungsprozesses gefertigten metallischen Körper (40) mit einer Fügefläche (42) aufweist,
wobei der Körper (40) derart mit der Fügefläche (42) wärmeleitend an die thermische Schnittstelle (210) gelötet ist, dass ein Lotmaterial (60) und die Metallpartikel (50) intermetallische Phasen (56) ausbilden.

12. Leistungselektronische Baugruppe (200), die zumindest
- ein Substrat (220) mit einer Metallisierung (230),
- ein oder mehrere leistungselektronische Halbleiterbauelemente (240) und
- einen mittels eines pulverbasiert additiven Fertigungsprozesses gefertigten metallischen Körper (40) mit einer Fügefläche (42) aufweist,
wobei der Körper (40) derart mit der Fügefläche (42) wärmeleitend an zumindest eines der leistungselektronischen Halbleiterbauelemente (240) gelötet ist, dass ein Lotmaterial (60) und die Metallpartikel (50) intermetallische Phasen (56) ausbilden.

13. Leistungselektronische Baugruppe (200) nach Anspruch 10, 11 oder 12, wobei die Metallpartikel (50) aus dem Material bestehen, das zum Herstellen des Körpers (40) verwendet wurde.

14. Halbzeug aufweisend einen mittels eines pulverbasierten additiven Fertigungsprozesses gefertigten metallischen Körper (40), der zumindest an einer Fügefläche (42) Metallpartikel (50) aufweist, die aus dem additiven Fertigungsprozess stammen, wobei auf der Fügefläche (42) ein Lotmaterial (60) aufgebracht ist, sodass die Metallpartikel (50) zwischen dem Lotmaterial (60) und der Fügefläche (42) eingeschlossen sind.
